# EUROPÄISCHE PATENTSCHRIFT

(11) **EP 0 525 624 B1**
(45) Veröffentlichungstag und Bekanntmachung des Hinweises auf die Patenterteilung: **11.09.1996**
(21) Anmeldenummer: 92112558.9
(22) Anmeldetag: 22.07.1992
(51) Int. Cl.: G03F 7/11, G03F 3/10

(54) **Verfahren zur Herstellung eines Mehrfarbenbilds und lichtempfindliches Material zur Durchführung dieses Verfahrens**
Method for producing a multicoloured image and photosensitive material for implementing this method
Procédé pour fabriquer une image multicolore et matériel photosensible pour la mise en oeuvre de ce procédé

(30) Priorität: 02.08.1991 DE 4125723
(43) Veröffentlichungstag der Anmeldung: 03.02.1993
(73) Patentinhaber: Agfa-Gevaert AG, D-51373 Leverkusen (DE)
(72) Erfinder: März, Karin, Dr., W-6500 Mainz (DE); Platzer, Stefan J. W., Dr., W-6228 Eltville-Erbach (DE)

(56) Entgegenhaltungen:
- EP-A- 0 104 954
- EP-A- 0 339 860
- EP-A- 0 352 055
- GB-A- 1 188 921

## Beschreibung

Die Erfindung betrifft ein lichtempfindliches, insbesondere photopolymerisierbares Material für die Herstellung von Farbprüffolien für den Mehrfarbendruck. Sie betrifft ferner ein Farbprüfverfahren, bei dem auf einem Bildempfangsmaterial ein Mehrfarbenbild aus mehreren Teilfarbenbildern im Register erzeugt wird. Die Teilfarbenbilder werden durch Laminieren einer in einer Grundfarbe eingefärbten photopolymerisierbaren Schicht auf das Bildempfangsmaterial, Belichten unter dem zugehörigen Farbauszug, Entwickeln des Bilds durch Abziehen der Trägerfolie der photopolymerisierbaren Schicht zusammen mit den Nichtbildstellen und Wiederholen der gleichen Schritte mit einer photopolymerisierbaren Schicht einer anderen Grundfarbe hergestellt.

Ein derartiges Farbprüfverfahren und ein hierfür vorgesehenes Material sind aus der US-A 4 895 787 bekannt. Dieses Material besteht aus einer transparenten Trägerfolie, deren Oberfläche vorzugsweise haftvermittelnd vorbehandelt worden ist, einer photopolymerisierbaren Schicht, die einen Farbstoff oder ein Farbpigment in einer Grundfarbe des Mehrfarbendrucks enthält und einer durch Erwärmen aktivierbaren Haftschicht auf der photopolymerisierbaren Schicht. Das Material wird nach Laminieren auf ein Bildempfangsmaterial und Belichten durch die Trägerfolie durch Auseinanderziehen ("peel apart") von Trägerfolie und Bildempfangsmaterial entwickelt, wobei die belichteten Bereiche der lichtempfindlichen Farbschicht an der Trägerfolie, die unbelichteten Bereiche zusammen mit der gesamten Haftschicht auf dem Bildempfangsmaterial verbleiben. Das Verfahren arbeitet also positiv, d. h. auf dem Bildempfangsmaterial entsteht ein positives Abbild der Vorlage.

Dieses Verarbeitungsverfahren hat den großen Vorteil, daß es zur Entwicklung keine alkalischen oder sauren Lösungen und keine organischen Lösemittel erfordert, deren Entsorgung damit entfällt. Ein Nachteil dieses Verfahrens ist seine geringere Auflösung im Vergleich zu einem Entwicklungsverfahren durch Auswaschen.

Welche Materialeigenschaften das Auflösungsvermögen beeinflussen, ist in einer Veröffentlichung von J.H. Choi, J. of Im. Tech., Bd 15, 4, 190 (1989) untersucht und beschrieben worden. Im wesentlichen sind es die Haftkräfte zwischen
a) den unbelichteten Bereichen der photopolymerisierbaren Farbschicht und der Trägerfolie,
b) den belichteten Bereichen der photopolymerisierbaren Farbschicht und der Trägerfolie,
c) den unbelichteten Bereichen der photopolymerisierbaren Farbschicht und der Haftschicht,
d) den belichteten Bereichen der photopolymerisierbaren Farbschicht und der Haftschicht sowie die Kohäsionskräfte
e) innerhalb der photopolymerisierbaren Farbschicht und
f) innerhalb der Haftschicht.

Die Kohäsionskräfte sind dabei meist größer als die genannten Haftkräfte, zumindest aber größer als die jeweils kleinste Haftkraft, und die Haftkraft zwischen der Haftschicht und dem Bildempfangsmaterial soll ebenfalls größer sein als alle übrigen Haftkräfte.

Ein weiterer Nachteil des bekannten Materials ist seine in vielen Fällen zu geringe Lagerfähigkeit. Wenn das Material bei Raumtemperatur einige Wochen im unbelichteten Zustand gelagert wird, so verändert es seine Eigenschaften derart, daß die Bildwiedergabe nach dem Belichten und Entwickeln schlechter wird. Dies äußert sich in sichtbaren Fehlstellen in den Rasterbildern, die durch ein ungenaues Ausreißen oder Zerreißen von Rasterpunkten bedingt sind. Bei erhöhter Temperatur ist diese Veränderung schon nach einem oder wenigen Tagen zu beobachten.

Aus der EP-A 339 860 ist ein Farbprüfverfahren bekannt, das mit einem ähnlich aufgebauten Material aus Trägerfolie, lichtempfindlicher, Pigment enthaltender Schicht und Haftschicht arbeitet. Die einzelnen Teilfarbenbilder werden hier durch Auswaschen der Nichtbildstellen mit einem Entwickler erzeugt. Bei diesem Verfahren spielt naturgemäß die Haftung der einzelnen Schichten nicht die Rolle wie bei einem peel-apart-Verfahren. Hierbei wird der Haftschicht ein Polyvinylether als Weichmacher zugesetzt.

Aufgabe war es, ein lichtempfindliches Material und ein Farbprüfverfahren der zuerst beschriebenen Gattung zur Verfügung zu stellen, die eine bessere Bildauflösung und Lagerfähigkeit ergeben.

Gegenstand der Erfindung ist ein lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
   B1) ein polymeres Bindemittel,
   B2) eine radikalisch polymerisierbare Verbindung,
   B3) eine Verbindung, die unter Einwirkung von aktinischem Licht die Polymerisation von (B2) einzuleiten vermag, und
   B4) einen Farbstoff oder ein Farbpigment in einer Grundfarbe des Mehrfarbendrucks enthält, und
C) einer thermoplastischen Haftschicht auf der lichtempfindlichen Schicht.

Das erfindungsgemäße Material ist dadurch gekennzeichnet, daß in mindestens einer der Schichten (B) und (C) ein Polymerisat eines Vinylalkylethers enthalten ist.

Gemäß einem anderen Aspekt der Erfindung wird ein Verfahren zur Herstellung eines Mehrfarbenbilds vorgeschlagen, das dadurch gekennzeichnet ist, daß man ein lichtempfindliches Material der vorstehend angegebenen Zusammensetzung mit der Haftschicht unter Druck auf ein Bildempfangsmaterial laminiert, durch die Trägerfolie hindurch mit einem Farbauszug bildmäßig belichtet, die Trägerfolie zusammen mit den Nichtbildstellen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

Das Vinylalkylether-Polymerisat kann in der photopolymerisierbaren Schicht B oder in der Haftschicht C oder in beiden Schichten enthalten sein. Der Zusatz bewirkt im allgemeinen eine Erhöhung des Haftvermögens der entsprechenden Schicht. So wird durch Zusatz zur photopolymerisierbaren Schicht sowohl deren Kohäsion als auch ihre Haftung zur Haftschicht in den unbelichteten Bereichen verbessert. Durch Zusatz zur Haftschicht wird ebenfalls deren Kohäsion und ihre Haftung zu den unbelichteten Bereichen der photopolymerisierbaren Schicht verbessert. Durch Messung der Abziehkräfte kann weiterhin festgestellt werden, daß sich die Haftung der unbelichteten Bereiche der photopolymerisierbaren Schicht zur Trägerfolie und die der belichteten Bereiche zur Haftschicht durch Zusatz des Vinyletherpolymerisats nicht ändert.

Wenn das Vinyletherpolymerisat der Haftschicht zugesetzt wird, wird auch die Haftung der letzteren zum Bildempfangsmaterial erhöht. Das bedeutet, daß man auch übliches matt oder glänzend beschichtetes Druckpapier für diesen Zweck einsetzen kann. Ohne diesen Zusatz zur Haftschicht muß das als Empfangsmaterial dienende Papier zusätzlich mit einer Haftschicht versehen werden, oder es muß ein kunststoffbeschichtetes Spezialpapier eingesetzt werden. Das Aufbringen der Haftschicht auf das Empfangsmaterial stellt nicht nur einen zusätzlichen Arbeitsschritt dar, sondern erhöht auch die Tonwertzunahme des Farbprüfbilds und verändert damit die Farbwiedergabe.

Das Vinylalkylether-Polymerisat kann ein Homo- oder Copolymerisat sein. Als Comonomere kommen grundsätzlich alle mit Vinylalkylethern copolymerisierbaren Vinylverbindungen in Betracht. Bevorzugt werden ungesättigte Carbonsäuren und ihre Derivate, z. B. die Ester und Amide von α,ß-ungesättigten Monocarbonsäuren, insbesondere von Acryl- und Methacrylsäure, die Anhydride, Ester, Partialester, Imide und Amide von Dicarbonsäuren, wie Malein-, Fumar- oder Citraconsäure. Auch Salze der Säuren können eingesetzt werden. Die Comonomeren können in einem Anteil von 0 bis 80 mol-% im Copolymeren enthalten sein. Der Vinylalkylether hat im allgemeinen eine Alkylgruppe mit 1 bis 8, vorzugsweise 1 bis 4 Kohlenstoffatomen, der Vinylmethylether wird besonders bevorzugt, da er wasserlösliche Polymerisate ergibt. Im allgemeinen werden auch die Vinylalkylether-Homopolymerisate gegenüber den Copolymerisaten bevorzugt.

Der Mengenanteil des Vinyletherpolymerisats in der photopolymerisierbaren oder der Haftschicht beträgt im allgemeinen 1 bis 10, bevorzugt 2 bis 5 Gew.-%.

Der Zusatz des Vinyletherpolymerisats zur Haftschicht hat im allgemeinen eine bessere Wirkung als der zur photopolymerisierbaren Schicht. Wenn jedoch die Haftschicht, wie häufig bevorzugt, aus wäßriger Lösung auf die photopolymerisierbare Schicht aufgebracht werden soll, um deren Bestandteile nicht anzulösen, so muß das Vinyletherpolymerisat wasserlöslich sein. In diesem Fall ist besonders der Polyvinylmethylether geeignet. Andere, wasserunlösliche Vinyletherpolymerisate müssen dann der photopolymerisierbaren Schicht zugesetzt werden, wenn aus homogener Lösung beschichtet werden soll. Es ist aber auch möglich, wäßrige Dispersionen dieser und anderer wasserunlöslicher Polymerer zur Beschichtung einzusetzen.

Die photopolymerisierbare Schicht des erfindungsgemäßen Materials enthält als wesentliche Bestandteile ein polymeres Bindemittel, eine radikalisch polymerisierbare Verbindung, eine Verbindung, die bei Einwirkung von aktinischem Licht freie Radikale bildet und damit die Polymerisation der polymerisierbaren Verbindung einleitet, und einen Farbstoff oder ein Farbpigment in einer Grundfarbe des Mehrfarbendrucks. Beispiele für photopolymerisierbare Schichten dieser Zusammensetzung sind in der US-A 4 895 787 beschrieben, auf die hier Bezug genommen werden soll.

Das polymere Bindemittel soll der Schicht Homogenität und Festigkeit verleihen. Geeignete Bindemittel sind Styrol/Maleinsäureanhydrid- und Styrol/Maleinsäurehalbester-Copolymere, Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 15 bis 70, vorzugsweise 20 bis 50 Gew.-%, bezogen auf das Gewicht der festen Schicht.

Die polymerisierbare Verbindung enthält mindestens eine, bevorzugt mindestens zwei endständige radikalisch polymerisierbare Doppelbindungen und ist bei Temperaturen unterhalb 100 °C und bei Normaldruck nicht gasförmig. Bevorzugt werden Ester und Amide der Acryl- und Methacrylsäure. Besonders die Ester mit mehrwertigen Alkoholen werden mit Vorteil eingesetzt. Beispiele sind Di-, Tri-, Tetra- und Polyethylenglykoldi(meth)acrylat, die Di(meth)acrylate von Oligo- und Polypropylenglykolen, 1,4-Butandioldi(meth)acrylat, Trimethylolpropan- und Trimethylolethandi- und -tri(meth)acrylat, Pentaerythrittri- und -tetraacrylat oder -methacrylat, Dipentaerythrittetra-, -penta- und -hexa(meth)acrylat. Der Mengenanteil an polymerisierbarer Verbindung beträgt im allgemeinen 15 bis 70, vorzugsweise 20 bis 60 Gew.-%.

Als Photoinitiatoren sind im wesentlichen alle für diesen Zweck bekannten Verbindungen oder Verbindungskombinationen geeignet. Beispiele sind Benzoinether, Benzilketale, Mehrkernchinone, Benzophenonderivate, Triarylimidazolyldimere, lichtempfindliche Trihalogenmethylverbindungen, z. B. Trichlormethyl-s-triazine. Besonders bevorzugt werden 2,3-Bis-aryl-chinoxaline, wie sie in der US-A 3 765 898 beschrieben sind, und 2-Ary1-4,6-bis-trichlormethyl-s-triazine. Die Menge an Photoinitiator bzw. an Photoinitiatorkombination liegt im allgemeinen zwischen 1 und 25, vorzugsweise zwischen 5 und 15 Gew.-%.

Die Farbstoffe bzw. Farbpigmente werden so ausgewählt, daß sie den Grundfarben des Mehrfarbendrucks, Cyan (Blaugrün); Magenta (Purpur); Gelb und Schwarz, entsprechen. Pigmente werden im allgemeinen bevorzugt. Beispiele sind Permanentgelb G (C.I. 21 095), Permanentgelb GR (C.I. 21 100), Permanentgelb DHG (C.I. 21 090), Permanentrubin L3B (C.I. 15 850 : 1), Permanent Pink F3B (C.I. 12 433), Hostaperm Pink E (C.I. 73 915), Hostaperm Rotviolett ER (C.I. 46 500), Permanentkarmin FBB (C.I. 12 485), Hostapermblau B2G (C.I. 74 160), Hostapermblau A2R (C.I. 74 160) und Printex 25 (Ruß). Die Pigmente können ggf. zur Erzielung des gewünschten Farbtons abgemischt werden. Die anorganischen oder organischen Pigmente werden im allgemeinen zusammen mit einem Teil des Bindemittels in einem geeigneten Lösemittel dispergiert oder angeteigt. Die mittlere Partikelgröße liegt i. a. unterhalb 1 µm.

Der Mengenanteil des Farbstoffs oder Pigments beträgt im allgemeinen 8 bis 40, vorzugsweise 12 bis 30 Gew.-%.

Die photopolvmerisierbare Schicht kann ggf. weitere Bestandteile, wie Wasserstoffdonatoren, Sensibilisatoren, Polymerisationsinhibitoren, Weichmacher, Restlöser, Tenside, Oberflächenausgleichsmittel, Gleitmittel, Antistatika, inerte Füllstoffe, optische Aufheller und/oder UV-Absorber, enthalten. Sie hat im allgemeinen ein Schichtgewicht von 0,2 bis 5, bevorzugt 0,3 bis 3 g/m².

Nach dem Trocknen der photopolymerisierbaren Schicht wird auf diese eine wärmeaktivierbare thermoplastische Haftschicht aufgebracht. Diese kann entweder aus einem Lösemittel oder Lösemittelgemisch, das die photopolymerisierbare Schicht nicht anlöst, direkt auf diese aufgebracht und getrocknet werden. Sie kann auch zuerst auf eine temporäre Trägerfolie aufgebracht und von dort durch Laminieren und Abziehen der Trägerfolie auf die photopolymerisierbare Farbschicht übertragen werden. Gemäß einer anderen Ausführungsform kann die Haftschicht durch Beschichten des Bildempfangsmaterials aus einem Lösemittel und Trocknen erhalten werden. Auf die so erhaltene Haftschicht wird dann die photopolymerisierbare Schicht durch Laminieren übertragen. Das direkte Aufbringen aus Lösemitteln auf die photopolymerisierbare Schicht wird bevorzugt. Geeignete Lösemittel, die die Farbschicht nicht anlösen, sind Wasser und gesättigte Kohlenwasserstoffe. Viele Polymere können aus wäßriger Dispersion aufgebracht werden; das Aufbringen aus Lösung wird aber bevorzugt. Hierfür eignen sich z. B. Salze von Polymerem mit Säuregruppen, z. B. Carboxylgruppen. Ein bevorzugtes Beispiel ist eine wäßrig-alkalische Lösung eines Vinylacetat/Crotonsäure-Copolymeren (Mowilith Ct 5)®. Andere geeignete Polymere sind Polyvinylacetat- oder Polyacrylatdispersionen. Das Polymere sollte eine Erweichungstemperatur im Bereich von 40 bis 200, vorzugsweise von 60 bis 120 °C haben. Die Haftschicht kann außer dem thermoplastischen Polymeren und dem Vinyletherpolymeren noch Weichmacher, Restlöser, Oberflächenausgleichsmittel, Tenside, Gleitmittel, Antistatika, inerte Füllstoffe, optische Aufheller und/oder UV-Absorber enthalten. Ihr Schichtgewicht im trockenen Zustand beträgt normalerweise 2 bis 30, vorzugsweise 4 bis 15 g/m². Geeignete Haftschichten sind auch in der US-A 4 895 787 beschrieben.

Als Trägerfolien werden transparente, flexible, dimensionsstabile Folien aus Kunststoffen, z. B. Polyestern, Polycarbonaten usw., eingesetzt. Besonders bevorzugt werden Polyesterfolien, insbesondere biaxial verstreckte und wärmefixierte Folien, z. B. aus Polyethylenterephthalat. Diese sollten bei den erforderlichen Laminiertemperaturen, d. h. von etwa 60 bis 150 °C maßhaltig bleiben. Ihre Dicke beträgt im allgemeinen 10 bis 200, vorzugsweise 25 bis 80 µm. Die Trägerfolie wird vorteilhaft ein- oder beidseitig haftvermittelnd vorbehandelt und kann eine glatte oder eine rauhe bzw. matte, vorzugsweise eine glatte Oberfläche haben.

Zur Durchführung des erfindungsgemäßen Verfahrens wird das oben beschriebene lichtempfindliche Material mit der Haftschicht auf ein Bildempfangsmaterial laminiert. Dieses kann aus Kunststoff, kunststoffbeschichtetem Spezialpapier oder aus normalem Bedruckpapier bestehen. Andere weiße und ggf. auch nicht-weiße Empfangsmaterialien können ebenfalls verwendet werden. Ein unter den Laminierbedingungen maßhaltiges Bedruckpapier wird gewöhnlich bevorzugt, da damit ein dem späteren Druck weitgehend nahekommender visueller Eindruck erzielt wird. Das Laminieren erfolgt zweckmäßig in einem hierfür vorgesehenen Gerät unter Druck und bei erhöhter Temperatur. Die Laminiertemperatur liegt gewöhnlich im Bereich von 60 bis 130, bevorzugt zwischen 70 und 100 °C. Nach dem Laminieren wird die photopolymerisierbare Schicht durch die Trägerfolie hindurch bildmäßig, i. a. im Kontakt unter einem Positiv-Farbauszug in bekannter Weise belichtet. Nach dem Belichten wird die Trägerfolie mit der Hand oder in einer geeigneten Vorrichtung abgezogen. Der Abziehwinkel sollte mindestens 90° betragen, ein Winkel von 180° wird besonders bevorzugt. Dabei werden die belichteten Bereiche der photopolymerisierbaren Schicht mit der Trägerfolie entfernt, während die unbelichteten zusammen mit der gesamten Haftschicht auf dem Bildempfangsmaterial verbleiben. Auf diese Weise wird ein positives Teilfarbenbild erhalten. Jede weitere Farbprüffolie wird in der beschriebenen Weise auf das vorangehende Teilfarbenbild laminiert, dort im Register belichtet und durch Abziehen der Trägerfolie entwickelt. So wird aus den Teilfarbenbildern der Farben Cyan (Blaugrün), Magenta (Purpur), Gelb und Schwarz ein vollständiges Mehrfarbenbild erzeugt, das dem späteren 4-Farben-Druckbild entspricht. Bei Bedarf können selbstverständlich auch Farbprüffolien in Sonderfarben eingesetzt werden.

Das fertige Mehrfarbenbild hat eine glänzende Oberfläche. Nach Wunsch kann die Oberfläche mattiert werden, indem z. B. eine Folie mit rauher Oberfläche auf die glänzende Schichtoberfläche laminiert und wieder abgezogen wird. Die Oberfläche des fertigen Prüfbilds kann mit einer Schutzschicht gegen Verkratzen oder Verkleben bei höheren Temperaturen geschützt werden.

Die Erfindung wird durch die folgenden Beispiele erläutert. Alle Prozentangaben und Mengenverhältnisse sind in Gewichtseinheiten zu verstehen. Die Beispiele 1 und 3 sind Vergleichsbeispiele ohne den erfindungsgemäßen Zusatz bzw. mit anderen Zusätzen. Das Beispiel 2 demonstriert demgegenüber die Vorteile der Erfindung.

### Beispiel 1 (Vergleichsbeispiel)

Die Beschichtungslösungen für die photopolymerisierbaren Schichten bestehen aus folgenden Komponenten in Gewichtsteilen:

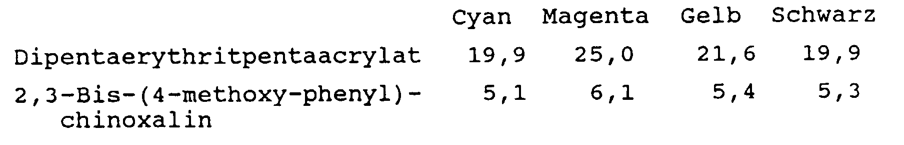

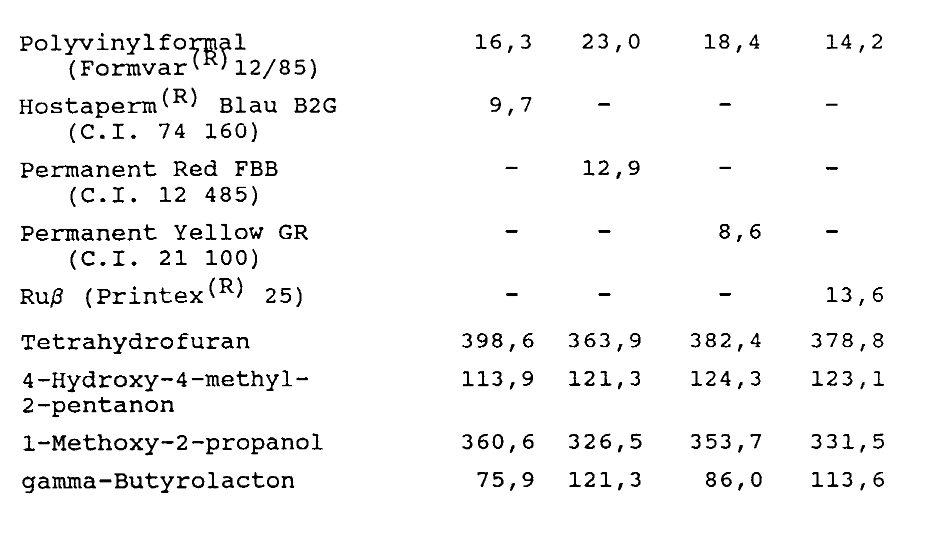

Die Pigmente werden mit einem Teil des Bindemittels und des Butyrolactons dispergiert. Die mittlere Teilchengröße liegt unterhalb von 200 nm. Die Dispersion und die übrigen Bestandteile werden gemischt und auf eine 50 µm dicke biaxial verstreckte und thermofixierte Polyethylenterephthalatfolie, die auf beiden Seiten zur Haftverbesserung vorbehandelt worden ist, (Melinex^{(R)} 505) aufgetragen. Die Schichten werden bei 70 °C getrocknet. Die Schichtgewichte liegen zwischen 0,6 und 0,8 g/m².

Die Haftschichtlösung setzt sich wie folgt zusammen:

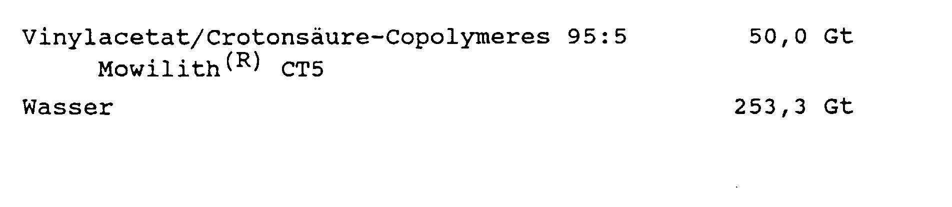

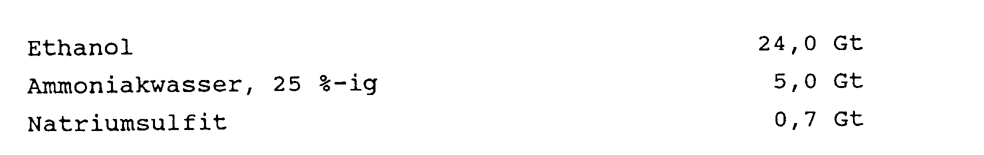

Die Lösung wird auf die trockenen photopolymerisierbaren Schichten aufgetragen und getrocknet. Das Schichtgewicht der trockenen Haftschicht beträgt 6 g/m².

Eine der so hergestellten Folien, z. B. die Cyan-Farbfolie, wird bei 85 °C auf kunststoffbeschichtetes Spezialpapier laminiert und unter dem Cyan-Farbauszugsfilm belichtet. Die Trägerfolie wird kontinuierlich in einem Winkel von 180° von Hand abgezogen. Auf dem Papier verbleiben die Haftschicht und das positive Cyan-Bild, auf das nacheinander die weiteren Farbfolien laminiert werden.

Der Tonwertumfang beträgt in einem Raster von 60 Linien/cm für die Buntfarben 4 - 96 % und im Fall von Schwarz 3 - 97 %, d.h. es werden die Rasterpunkte, deren Größe der angegebenen Flächendeckung in % entspricht, noch wiedergegeben. Bereits nach 24-stündiger Lagerung der unbelichteten Folien bei 48 °C zeigen sich bei der Verarbeitung sichtbare Ausrisse in den Bildpunkten. In der Vergrößerung ist ein Zerreißen der Konturen der Rasterpunkte und eine Zerstörung der Haftschichtoberfläche in ihrer Umgebung nach dem Abziehen zu erkennen. Herkömmliche Druckpapiere (z.B. Chromolux^{(R)} 500/250) können aufgrund der schlechten Haftung der Haftschicht nicht als Trägermaterial verwendet werden. Hier ist die Vorbehandlung des Papiers mit einer zusätzlichen Haftschicht erforderlich, wie es z. B. in der EP-A 0 365 358 beschrieben ist.

### Beispiel 2

Die Zusammensetzung der photopolymerisierbaren Farbschichten entspricht den Angaben von Beispiel 1; es werden aber der Farb- und/oder der Haftschicht Vinyletherpolymere als Haftvermittler zugesetzt. Die Weiterverarbeitung und Verwendung der Folien erfolgt wie in Beispiel 1. Die Tabellen 2.1 - 2.4 zeigen die jeweils eingesetzten Konzentrationen und den Tonwertumfang in einem Raster von 60 Linien/cm (c_{A} = Konzentration des Haftvermittlers in der Haftschicht, c_{F} = Konzentration des Haftvermittlers in der Farbschicht; beide Angaben in Gewichtsprozent des Feststoffgehaltes der jeweiligen Schicht). Die Beurteilung der Lagerfähigkeit bzw. Thermostabilität erfolgt aufgrund der Rasterpunktform. Der angegebene Zeitraum sagt aus, ab wann das in Beispiel 1 beschriebene Zerreißen der Rasterpunktkonturen auftritt (Lagertemperatur 50 °C). Die Lagerfähigkeit wurde in allen Fällen an der Magenta-Folie geprüft. In einer Anzahl von Fällen wurden auch die Folien der anderen Buntfarben (Gelb und Cyan) und die Schwarz-Folie geprüft. Dabei wurden jeweils die gleichen Ergebnisse wie bei der Magenta-Folie erhalten. Soweit zutreffend, sind in Klammern hinter der Zeitangabe die weiteren Farben angegeben, für die die Lagerfähigkeit ermittelt wurde.

Dabei bedeuten:
C = Cyan
Y = Gelb (Yellow)
K = Schwarz

### 2.1 Polyvinylmethylether, Mw=70.000 (Lutonal^{(R)} M40, BASF)

| Nr. | c_{A} | c_{F} | Tonwertumfang | Thermostabilität (50 °C) |
|---|---|---|---|---|
| 2.1.1 | 1.0 | - | 3-98 % | > 48 h (C) |
| 2.1.2 | 2.0 | - | 2-98 % | > 7 Wochen (C,Y,K) |
| 2.1.3 | 5.0 | - | 2-98 % | > 7 Wochen (C,Y,K) |
| 2.1.4 | 10.0 | - | 4-98 % | > 7 Wochen (C) |
| 2.1.5 | 2.0 | 2.0 | 2-98 % | > 7 Wochen |
| 2.1.6 | - | 2.5 | 2-97 % | > 24 h |
| 2.1.7 | - | 5.0 | 2-98 % | > 24 h |

### 2.2 Polyvinylethylether, M_{w}=5800 (Lutonal^{(R)}A25, BASF)

| Nr. | c_{A} | c_{F} | Tonwertumfang | Thermostabilität (50 °C) |
|---|---|---|---|---|
| 2.2.1 | - | 1.0 | 3-97 % | > 4 Tage (C,K) |
| 2.2.2 | - | 2.5 | 2-97 % | > 4 Tage (C,K) |
| 2.2.3 | - | 5.0 | 2-98 % | > 7 Tage (C,K) |

### 2.3 Copolymeres Vinylmethylether/Maleinsäureanhydrid, M_{w}=41.000 (Gantrez^{(R)} AN139, GAF)

| Nr. | c_{A} | c_{F} | Tonwertumfang | Thermostabilität (50 °C) |
|---|---|---|---|---|
| 2.3.1 | - | 2.0 | 3-98 % | > 48 h |
| 2.3.2 | - | 5.0 | 2-97 % | > 24 h |

### 2.4 Copolymeres Vinylisobutylether/Acrylsäureester (Acronal^{(R)} 700L, BASF)

| Nr. | c_{A} | c_{F} | Tonwertumfang | Thermostabilität (50 °C) |
|---|---|---|---|---|
| 2.4.1 | - | 1.0 | 3-98 % | > 65 h |
| 2.4.2 | - | 2.5 | 2-98 % | > 65 h |
| 2.4.3 | - | 5.0 | 2-98 % | > 65 h |

Die Tabellen 2.1 bis 2.4 zeigen deutlich die Vorteile des Haftvermittlereinsatzes:
1) Das Auflösungsvermögen wird verbessert. Bei allen vier Farben kann ein Tonwertumfang von 2-98 % in einem Raster von 60 Linien/cm erreicht werden.
2) Die Thermostabilität wird erhöht.

Mit steigender Konzentration des Haftvermittlers in der Haftschicht wird außerdem die Haftung der Farbprüffolie auf Druckpapier (Chromolux^{(R)}500/250) verbessert, so daß die Verwendung kunststoffbeschichteter Spezialpapiere oder zusätzlicher Papierhaftschichten nicht mehr notwendig ist (Beispiele 2.1.1 - 2.1.4 auf Druckpapier). Allerdings nimmt gleichzeitig die Oberflächenklebrigkeit der Haftschicht zu; die am meisten bevorzugte Konzentration des Haftvermittlers ist daher 2-5 %, bezogen auf den Feststoffgehalt der Haftschicht.

### Beispiel 3

Die Lösungen für die photopolymerisierbaren Farbschichten entsprechen den Angaben von Beispiel 2. Anstelle der Haftvermittler werden sowohl in der Farb- als auch in der Haftschicht die folgenden Weichmacher eingesetzt. Die Weiterverarbeitung und Verwendung der Folien folgt der Beschreibung in Beispiel 1.
3a) Das Vinyletherpolymere in der Farbschicht wird durch die gleiche Menge Dibutylphthalat ersetzt. Im Vergleich zu den zusatzfreien Mustern aus Beispiel 1 zeigt sich weder ein ein positiver noch ein negativer Einfluß auf die Auflösung oder die Thermostabilität.
3b) Das Vinyletherpolymere in der Farbschicht wird durch die gleiche Menge eines polymeren Weichmachers ersetzt, z. B. durch ein Polydiethylenglykoladipat (Resoflex^{(R)}R296 von Cambridge Ind.) oder durch einen anderen Polyester (Paraplex^{(R)}WP1 von Rohm and Haas). Im Fall eines Zusatzes von Resoflex R296 tritt eine deutliche Verschlechterung des Auflösungsvermögens, verbunden mit einem Bildstellenverlust, auf. Paraplex WP1 zeigt keinerlei Einfluß.
3c) Der Polyvinylmethylether in der Haftschicht wird gegen verschiedene Polyglykole mit einem Molekulargewicht zwischen 2.000 und 20.000 als wasserlösliche Weichmacher ausgetauscht. Nach 24-stündiger Lagerung der beschichteten Folien bei 48 °C zeigt sich eine deutliche Verschlechterung der Auflösung und ein Rückgang der Lichtempfindlichkeit.

## Patentansprüche

1. Lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
B1) ein polymeres Bindemittel,
B2) eine radikalisch polymerisierbare Verbindung,
B3) eine Verbindung, die unter Einwirkung von aktinischem Licht die Polymerisation von (B2) einzuleiten vermag, und
B4) einen Farbstoff oder ein Farbpigment in einer Grundfarbe des Mehrfarbendrucks enthält, und
C) einer thermoplastischen Haftschicht auf der lichtempfindlichen Schicht,
dadurch gekennzeichnet, daß in mindestens einer der Schichten (B) und (C) ein Polymerisat eines Vinylalkylethers enthalten ist.

2. Lichtempfindliches Material nach Anspruch 1, dadurch gekennzeichnet, daß das Polymerisat ein Homopolymerisat eines Vinylalkylethers ist.

3. Lichtempfindliches Material nach Anspruch 1, dadurch gekennzeichnet, daß das Polymerisat ein Mischpolymerisat eines Vinylalkylethers mit einem Derivat einer Alkenylcarbonsäure ist.

4. Lichtempfindliches Material nach Anspruch 1, 2 oder 3, dadurch gekennzeichnet, daß der Vinylalkylether eine Alkylgruppe mit 1 bis 4 Kohlenstoffatomen hat.

5. Lichtempfindliches Material nach Anspruch 1, dadurch gekennzeichnet, daß das Vinylalkylether-Polymerisat wasserlöslich ist.

6. Lichtempfindliches Material nach Anspruch 1, dadurch gekennzeichnet, daß das Vinylalkylether-Polymerisat in der jeweiligen Schicht in einer Menge von 1 bis 10 Gew.-%, bezogen auf die nichtflüchtigen Bestandteile der Schicht, enthalten ist.

7. Lichtempfindliches Material nach Anspruch 1, dadurch gekennzeichnet, daß die thermoplastische Haftschicht eine Glastemperatur Tg von 20 bis 60 °C hat.

8. Lichtempfindliches Material nach Anspruch 1, dadurch gekennzeichnet, daß die thermoplastische Haftschicht ein Gewicht von 2 bis 30 g/m² hat.

9. Lichtempfindliches Material nach Anspruch 1, dadurch gekennzeichnet, daß die photopolymerisierbare Schicht ein Gewicht von 0,2 bis 5 g/m² hat.

10. Verfahren zur Herstellung eines Mehrfarbenbilds, dadurch gekennzeichnet, daß man ein lichtempfindliches Material der in Anspruch 1 angegebenen Zusammensetzung mit der Haftschicht unter Druck auf ein Bildempfangsmaterial laminiert, durch die Trägerfolie hindurch mit einem Farbauszug bildmäßig belichtet, die Trägerfolie zusammen mit den Nichtbildstellen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

11. Verfahren nach Anspruch 10, dadurch gekennzeichnet, daß das Bildempfangsmaterial Papier ist.

12. Verfahren nach Anspruch 11, dadurch gekennzeichnet, daß das Papier ein übliches Bedruckpapier ist, wie es für den Auflagendruck mit den entsprechenden Flachdruckplatten eingesetzt wird.

## Claims

1. A light-sensitive material for producing color-proofing films for multi-color printing with
A) a transparent flexible base film of a plastic,
B) a photopolymerizable layer which contains
B1) a polymeric binder,
B2) a compound polymerizable by a free-radical mechanism,
B3) a compound which is capable of initiating the polymerization of (B2) under the action of actinic light, and
B4) a dye or a colored pigment in one of the primary colors of the multi-colored print, and
C) a thermoplastic adhesion layer on the light-sensitive layer,
which material comprises a polymer of a vinyl alkyl ether in at least one of the layers (B) and (C).

2. The light-sensitive material as claimed in claim 1, wherein the polymer is a homopolymer of a vinyl alkyl ether.

3. The light-sensitive material as claimed in claim 1, wherein the polymer is a copolymer of a vinyl alkyl ether with a derivative of an alkenyl carboxylic acid.

4. The light-sensitive material as claimed in claim 1, 2 or 3, wherein the vinyl alkyl ether has an alkyl group with 1 to 4 carbon atoms.

5. The light-sensitive material as claimed in claim 1, wherein the vinyl alkyl ether polymer is watersoluble.

6. The light-sensitive material as claimed in claim 1, wherein the vinyl alkyl ether polymer is present in the particular layer in a quantity from 1 to 10% by weight, relative to the non-volatile constituents of the layer.

7. The light-sensitive material as claimed in claim 1, wherein the thermoplastic adhesion layer has a glass transition temperature Tg of from 20 to 60°C.

8. The light-sensitive material as claimed in claim 1, wherein the thermoplastic adhesion layer has a weight of from 2 to 30 g/m².

9. The light-sensitive material as claimed in claim 1, wherein the photopolymerizable layer has a weight of from 0.2 to 5 g/m².

10. A method of producing a multi-colored image, which comprises laminating a light-sensitive material of the composition indicated in claim 1 together with the adhesion layer under pressure to an image-receiving material, imagewise exposing the laminate through the base film with a color separation, peeling the base film together with the non-image areas off from the image-receiving material and repeating the steps of laminating, exposing and peeling-off with at least one further color separation, the exposure taking place in register with the first part-color image produced on the image-receiving material.

11. The method as claimed in claim 10, wherein the image-receiving material is paper.

12. The method as claimed in claim 11, wherein the paper is a conventional printing paper such as is used for a long print run with the corresponding planographic printing plates.

## Revendications

1. Matériau photosensible pour la fabrication d'épreuves de couleur pour l'impression polychrome comprenant :
A) une feuille de support en matière plastique, flexible, transparente,
B) une couche photopolymérisable, qui contient :
B1) un liant polymère
B2) un composé polymérisable par voie radicalaire
B3) un composé susceptible de déclencher la polymérisation de (B2) sous l'action de la lumière actinique et
B4) un colorant ou un pigment coloré d'une couleur de base de l'impression polychrome et
C) une couche adhésive thermoplastique déposée sur la couche photosensible,
caractérisé en ce qu'au moins une des couches (B) et (C) contient un produit de polymérisation d'un éther de vinyle et d'alkyle.

2. Matériau photosensible selon la revendication 1, caractérisé en ce que le produit de polymérisation est un produit d'homopolymérisation d'un éther de vinyle et d'alkyle.

3. Matériau photosensible selon la revendication 1, caractérisé en ce que le produit de polymérisation est un produit de copolymérisation d'un éther de vinyle et d'alkyle avec un dérivé d'un acide alcénylcarboxylique.

4. Matériau photosensible selon la revendication 1, 2 ou 3, caractérisé en ce que l'éther de vinyle et d'alkyle contient un groupe alkyle comportant 1 à 4 atomes de carbone.

5. Matériau photosensible selon la revendication 1, caractérisé en ce que le produit de polymérisation d'éther de vinyle et d'alkyle est soluble dans l'eau.

6. Matériau photosensible selon la revendication 1, caractérisé en ce que le produit de polymérisation d'éther de vinyle et d'alkyle est contenu dans la couche respective en une quantité de 1 à 10 % du poids des composants non volatils de la couche.

7. Matériau photosensible selon la revendication 1, caractérisé en ce que la couche adhésive thermoplastique a une température de transition vitreuse Tg de 20 à 60°C.

8. Matériau photosensible selon la revendication 1, caractérisé en ce que la couche adhésive thermoplastique a un poids de 2 à 30 g/m².

9. Matériau photosensible selon la revendication 1, caractérisé en ce que la couche photopolymérisable a un poids de 0,2 à 5 g/m².

10. Procédé de fabrication d'une image polychrome, caractérisé en ce qu'on lamine sous pression un matériau photosensible dont la composition est donnée par la revendication 1, avec la couche adhésive, sur un matériau de réception de l'image, on insole suivant une image avec une sélection chromatique à travers la feuille de support, on retire du matériau de réception de l'image la feuille de support avec les zones de non-image et on répète les étapes de laminage, insolation et séparation avec au moins un autre matériau photosensible d'une couleur de base, l'insolation se faisant en respectant les repères de la première image partielle en couleur produite sur le matériau de réception de l'image.

11. Procédé selon la revendication 10, caractérisé en ce que le matériau de réception de l'image est du papier.

12. Procédé selon la revendication 11, caractérisé en ce que le papier est un papier d'impression usuel, comme celui utilisé pour le tirage à l'aide des plaques d'impression à plat correspondantes.
